(19) Europäisches Patentamt
European Patent Office
Office européen des brevets

(11) **EP 2 036 113 B1**

(12) **EUROPÄISCHE PATENTSCHRIFT**

(45) Veröffentlichungstag und Bekanntmachung des Hinweises auf die Patenterteilung:
**08.05.2013 Patentblatt 2013/19**

(21) Anmeldenummer: 07764755.0

(22) Anmeldetag: **20.06.2007**

(51) Int Cl.:
*H01J 37/34* (2006.01)    *C23C 14/00* (2006.01)
*C23C 14/34* (2006.01)

(86) Internationale Anmeldenummer:
**PCT/EP2007/005442**

(87) Internationale Veröffentlichungsnummer:
**WO 2007/147582 (27.12.2007 Gazette 2007/52)**

(54) **VERFAHREN ZUR REGELUNG EINES REAKTIVEN HOCHLEISTUNGS-PULS-MAGNETRONSPUTTERPROZESSES UND VORRICHTUNG HIERZU**

METHOD FOR CONTROLLING A REACTIVE HIGH-POWER PULSED MAGNETRON SPUTTER PROCESS AND CORRESPONDING DEVICE

PROCEDE DE REGULATION D'UN PROCESSUS REACTIF DE PULVERISATION MAGNETRON A IMPULSIONS DE HAUTE PUISSANCE ET DISPOSITIF CORRESPONDANT

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **20.06.2006  DE 102006028303
22.12.2006  DE 102006061324**

(43) Veröffentlichungstag der Anmeldung:
**18.03.2009  Patentblatt 2009/12**

(73) Patentinhaber: **Fraunhofer-Gesellschaft zur Förderung der angewandten Forschung e.V.
80686 München (DE)**

(72) Erfinder:
• **RUSKE, Florian
  D-10249 Berlin (DE)**
• **SITTINGER, Volker
  38106 Braunschweig (DE)**
• **SZYSZKA, Bernd
  38108 Braunschweig (DE)**

(74) Vertreter: **Pfenning, Meinig & Partner GbR
Patent- und Rechtsanwälte
Theresienhöhe 13
80339 München (DE)**

(56) Entgegenhaltungen:
EP-A- 1 310 979    WO-A-01/16394
WO-A-01/38597    DE-C1- 19 506 515

• **W. D. SPROUL ET AL.: "The Reactive Sputter Deposition of Aluminum Oxide Coatings Using High Power Pulsed Magnetron Sputtering (HPPMS)" 47TH SVC ANNUAL TECHNICAL CONFERENCE PROCEEDINGS, 2004, Seiten 96-100, XP002452058 in der Anmeldung erwähnt**

**Beschreibung**

Die vorliegende Erfindung bezieht sich auf ein Verfahren zur Regelung eines reaktiven Hochleistungs-Puls-Magnetronsputterprozesses und eine Vorrichtung hierzu.

Das Verfahren ermöglicht die Stabilisation des reaktiven Sputterprozesses, so dass Schichten mit der gewünschten Morphologie und Phasenzusammensetzung auf einem Substrat abscheidbar sind.

Plasmasputtern ist eine etablierte Technologie für die Beschichtung von Substraten, insbesondere mit keramischen oder anderen mehrkomponentigen Funktionsschichten. Ein reaktiver Sputterprozess beruht hierbei auf dem Sputtern von metallischen Targets in einer reaktiven Gasatmosphäre, so dass auf dem Substrat eine Verbindung aus dem Targetmaterial und einer oder mehreren Komponenten des Prozessgases abgeschieden wird.

Aus dem Stand der Technik ist ein Verfahren zur reaktiven Beschichtung von Substraten in einer Zerstäubungseinrichtung nach dem Magnetron-Prinzip bekannt (DE 195 06 515 C1). Dabei wird vor dem Beschichten der Substrate die jedem Teiltarget zugeordnete Magnetfeldstärke ohne Reaktivgas eingestellt. Danach wird durch Regelung des Reaktivgasflusses ein vorgegebener Wertesatz charakteristischer Messgrößen eingestellt. Während der nun folgenden Beschichtung wird durch den regelbaren Reaktivgasfluss der für jedes Teiltarget vorgegebene Wertesatz konstant gehalten. Die beiden ersten Schritte werden in bestimmten Zeitabständen wiederholt.

Ein wesentliches Problem beim reaktiven Sputtern resultiert jedoch daraus, dass der Reaktivgas-Partialdruck nicht stetig verändert werden kann. Der Parameterraum zerfällt daher in die definierten Bereiche "Compound Mode" mit hohem Reaktivgas-Partialdruck und einer vollständig mit Reaktionsprodukten bedeckten Targetoberfläche sowie stöchiometrischen Schichten am Substrat und einem "Metallic Mode" mit einem geringen Reaktivgas-Partialdruck in der Sputterkammer, einer weitgehend metallischen Targetoberfläche und dem Aufwachsen von metallischen Schichten auf dem Substrat. Zwischen diesen Bereichen ist im allgemeinen kein stetiger Übergang möglich, es resultieren vielmehr instabile Prozesszustände, deren Zustandekommen im folgenden skizziert wird. Dabei wird beispielhaft auf das Reaktivgas $O_2$ Bezug genommen, die angeführten Mechanismen gelten jedoch auch für Sputtern in $N_2$, $CH_x$ und dgl.

Zu Beginn des Magnetronsputterns wird Reaktivgas in die Sputterkammer zugegeben. Daraufhin laufen auf der Targetoberfläche konkurrierende Wachstums- und Ätzprozesse ab. Bei niedrigem $O_2$-Partialdruck ist die Rate für das Aufwachsen der Oxidbedeckung gering, so dass der Ätzprozess durch den Sputterabtrag der Oxidschicht überwiegt. Die Targetoberfläche bleibt daher insgesamt metallisch. Dieser Zustand ist stabil, da das Target als effiziente Getterpumpe arbeitet, deren effektives Saugvermögen oftmals ein Vielfaches des Saugvermögens der eigentlich zur Evakuierung eingesetzten Turbopumpe beträgt.

Wird der Reaktivgas-Partialdruck erhöht, so wächst auf der Targetoberfläche eine Oxidschicht mit etwas höherer Rate auf. Bei geringen Ionenstromdichten und somit geringer Ätzrate überwiegt dann der Wachstumsprozess. Auf diese Weise entstehen mit Reaktionsprodukten bedeckte Targetbereiche, die auch als "vergiftete Targetbereiche" bezeichnet werden.

Diese vergifteten Targetbereiche weisen gegenüber dem Metall stets eine geringere Sputterausbeute auf, so dass insgesamt weniger Targetmaterial gesputtert wird. Dies führt zu einer Abnahme des Materialabtrags am Target, einer Verminderung des Targetsaugvermögens und damit zu einer weiteren Erhöhung des Reaktivgas-Partialdrucks.

Sobald der Reaktivgas-Partialdruck einen kritischen Wert überschreitet, kommt es folglich zu einem selbstverstärkenden Effekt, da die Erhöhung des Reaktivgas-Partialdrucks eine Verminderung des Saugvermögens der Target-Getterpumpe zur Folge hat, woraus wiederum eine Erhöhung des Reaktivgas-Partialdrucks resultiert. Diese Instabilität kennzeichnet den Übergang von Metallic Mode in den Compound Mode.

Technisch von großem Interesse ist nun gerade die Stabilisierung des unstetigen Übergangs zwischen diesen beiden Zuständen, da zum einen die Wachsturnsrate im Compound Mode bedingt durch die niedrige Sputterausbeute nur gering ist, andererseits die Schichten im Compound Mode unter Reaktivgasüberschuss aufwachsen, woraus ungünstige Schichteigenschaften resultieren. Im Übergangsbereich lassen sich somit nicht nur stöchiometrische Schichten bei höheren Raten als im "compound Mode" abscheiden, sondern auch Schichteigenschaften erzielen, die in den anderen Bereichen nicht erzielbar sind. Als Beispiel sei die Deposition von Al-dotiertem Zinkoxid angeführt: Das Material weist nur bei Deposition im Übergangsbereich sowohl hohe optische Transparenz als auch hohe elektrische Leitfähigkeit auf. Andererseits ist der Reaktivgas-Partialdruck im Metallic Mode im allgemeinen zu gering, so dass dann absorbierende unterstöchiometrische Verbindungen aufwachsen.

Die gewünschten stöchiometrischen Schichten können jedoch dann bei hoher Rate abgeschieden werden, wenn der Prozess genau im instabilen Übergangsbereich, der auch als "Transition Mode" bezeichnet wird, betrieben wird. Die Stabilisierung dieses unstetigen Übergangszustandes "Transition Mode" ist durch Regelkreise möglich, die das dynamische Verhalten der Quellen berücksichtigen und die so die technisch interessanten instabilen Arbeitspunkte aufrechterhalten können.

Zwischen den beiden Depositionsregimen (Compound Mode und Metallic Mode) ist somit kein stetiger Übergang möglich und es existieren keine stabilen Arbeitspunkte zur Stabilisation mittlerer Reaktivgaspartialdrücke. Um trotzdem den Prozess im technisch interessierenden Übergangsbereich betreiben zu können, sind aktive Regelsysteme notwendig (aktive Prozesskontrolle), bei denen eine äußere Stellgröße nach Maßgabe eines gemessenen Prozessparameters (Regelgröße) fortwährend angepasst wird. Es ist hierbei bekannt, zur Stabilisation des Prozesses die Anpassung der elektrischen Entladungsparameter Targetspannung oder Targetstrom nach Maßgabe eines primären Prozessparameters, wie z.B. des Partialdrucks der reaktiven Gaskomponenten oder der Plasmaemission, vorzunehmen. Als Stellgröße werden in diesem Fall somit die elektrischen Entladungsparameter Kathodenspannung oder Kathodenstrom eingesetzt. Auch ist es bekannt, den Reaktivgasfluss selbst als Stellgröße zu verwenden. Beide Systeme finden breite Anwendung.

Bei dem gemessenen Prozessparameter sind ebenfalls verschiedene Lösungen möglich. Reaktivgaspartialdrücke können mit Massenspektrometern, im Fall von Sauerstoff auch mit einer λ-Sonde, direkt gemessen werden. Auch der Totaldruck in der Kammer kann als Eingangsgröße dienen. Eine weitere Möglichkeit stellt die Messung der optischen Emission des Plasmas dar. Schließlich ist auch eine Messung der Kathodenspannung für verschiedene Materialien eine geeignete Lösung. In mit Wechselfeldern betriebenen Plasmen ist auch die Analyse von Fouriertransformierten von Spannungs- und Stromsignal der Entladung zielführend. So kann beispielsweise mit dem optischen Emissionsspektrometer die Emission der Metallatome im Plasma aufgenommen werden; der Reaktivgasfluss wird variiert, um Abweichungen der Emissionsintensität vom Sollwert abzugleichen. In einem anderen Beispiel wird bei der Deposition eines Metalloxids der Sauerstoffpartialdruck mit einer λ-Sonde beobachtet; bei Abweichungen vom Sollwert wird die Entladungsleistung des Generators angepasst.

Das Magnetronsputtern stellt eine bekannt, großtechnisch gut umsetzbare Methode dar, Schichten hoher Qualität auf verschiedenste Substrate abzuscheiden. Insbesondere eignet sich das Verfahren zur Abscheidung von keramischen oder anderen mehrkomponentigen Schichten.

Eine relativ neue Variante des Magnetronsputterns ist das sog. Hochleistungs-Puls-Magnetronsputtern (HPPMS oder HIPIMS), siehe auch D.J. Christie, Journal of Vacuum Science and Technology A 23 (2005), Seiten 330 bis 335 und Kouznetsov, V.; Macak, K.; Schneider, J.M.; Helmersson, U.; Petrov, I.: A novel pulsed magnetron sputter technique utilizing very high target power densities in: Surface and Coatings Technology 122 (1999), S. 290-3. Hierbei wird das Plasma durch einzelne Pulse hoher Leistungsdichte angeregt. Das Plasma selbst wird durch periodisches Entladen einer Kondensatorbank aufgebaut. Es handelt sich um einen gepulsten Prozess, bei dem die Leistungsdichte am Target etwa das 30 bis 100fache der beim DC-Betrieb üblichen Werte erreicht. Leistungsdichten weit oberhalb von 1 kW/cm$^2$ sind möglich. Unter solchen Bedingungen wird die Magnetron-Entladung im Übergang zur Arc-Entladung betrieben. Hierdurch kommt es zu einer erhöhten Ionisation des gesputterten Targetmaterials. Für das Sputtern von Metallen wurden bereits Ionisationsgrade von mehr als 80% gegenüber Werten von weniger als 1 % für den konventionellen Betrieb erreicht (D.J. Christie et al., 48th SVC Proceedings (2005)).

Aus dem Stand der Technik sind bereits verschiedene Arbeiten zum reaktiven Sputtern mittels HPPMS bekannt. Bei Benutzung einer aktiven Regelung wurde hierbei immer der Reaktivgasfluss als Stellgröße zur Stabilisation der Entladung im Übergangsbereich genutzt (siehe beispielsweise D.A. Glocker et al., 47th SVC Proceedings (2004), S. 183 und W.D. Sproul et al., 47th SVC Proceedings (2004), S. 96 ff.). Die Gasflussregelung hat hierbei den Vorteil, dass bereits vorhandene Hardware genutzt werden kann, ohne dass neue Software geschrieben werden muss (es muss also keine neue Regelung aufgebaut werden, sondern es wird auf eine Anlage mit funktionierender Gasflussregelung zurückgegriffen). Die Einstellung des Arbeitspunktes durch Variation des Reaktivgasflusses hat jedoch den Hauptnachteil einer vergleichsweise geringen Geschwindigkeit der Regelung: Im Allgemeinen wird eine Anpassung des Gasflusses erst mit kurzer Verzögerung im Prozess bemerkbar. Zudem sind die für eine schnelle Gasflussregelung notwendigen Einrichtungen, wie z.B. geeignete Gasverteiler und Massenflussregler, teuer.

Aufgabe der Erfindung ist es somit, ein Verfahren und eine Vorrichtung zur Stabilisation von Reaktivprozessen beim Hochleistungs-Puls-Sputtern zur Verfügung zu stellen, mit welchen auf einfache, schnelle und unkomplizierte Art und Weise und ohne die Prozesscharakteristik zu verändern, eine Stabilisation des Arbeitspunktes möglich ist.

Grundlegende Idee des Lösungsvorschlags der vorliegenden Erfindung ist es, beim Hochleistungs-Puls-Sputtern die Entladungsleistung durch eine Regelungsschleife geeignet (wie nachfolgend beschrieben) anzupassen, anstelle der Verwendung des Reaktivgasflusses als Stellgröße zur Stabilisation der Entladung wie beim Stand der Technik.

Grundlegendes Problem hierbei ist, dass bei Variation der Leistungsdichte innerhalb der einzelnen Entladungspulse die Prozesscharakteristik stark verändert wird und die Ionisationsrate sich somit spürbar ändert. Eine Stabilisation eines reaktiven Hochleistungs-Puls-Sputterprozesses kann daher nicht durch Anpassung der Leistung pro Puls durchgeführt werden. Dieses Problem wird durch Anpassung der Frequenz der Entladung unter Beibehaltung der Form der einzelnen Entladungsimpulse gelöst. Hierdurch wird die durchschnittliche Leistung variiert, ohne dass es zu einer Änderung der Prozesscharakteristik kommt. Bei genügend hohen Pulsfrequenzen kann somit die Entladung am gewünschten Arbeitspunkt stabilisiert werden.

Genügend hoch ist die Frequenz, wenn in den Pausen zwischen zwei Pulsen keine merkliche Änderung des Targetzustands stattfindet. Je nach Material sollte die Frequenz hierbei oberhalb von 20 Hz, vorzugsweise sogar über 100 Hz, liegen. Bei höheren Frequenzen ist mit einer besseren Prozessführung zu rechnen, beim Hochleistungssputtern ist die Frequenz nach oben durch die thermische Belastbarkeit des Targets limitiert.

Die erfindungsgemäße Anpassung der Entladungsleistung mittels Frequenzvariation basiert dabei auf folgenden Überlegungen:

Die durchschnittlich am Target anliegende Leistung für eine gepulste Plasmaentladung berechnet sich wie folgt:

$$\overline{P} = f * W_{Puls} \qquad (1)$$

Dabei bezeichnet f die Frequenz der Entladung und $W_{Puls}$ die Energie pro Puls. Sie ergibt sich aus dem Strom- und Spannungsverlauf innerhalb eines Pulses:

$$W_{Puls} = \int_\tau U(t) * I(t) dt \qquad (2)$$

Die Integration hat dabei über eine Pulsdauer zu erfolgen. Das Produkt aus Pulsdauer $\tau$ und Frequenz f wird auch als "duty cycle $\eta$" bezeichnet. Um nun eine Regelung eines Reaktivprozesses für Hochleistungs-Pulssputtern über Variation der Leistung zu realisieren, kann grundsätzlich nach Formel (1) entweder die Energie pro Puls $W_{Puls}$ oder die Frequenz f variiert werden. Bei dem Hochleistungs-Pulssputtern ist jedoch bei Änderung der Leistung pro Puls eine deutliche Änderung der Entladungscharakteristik zu beobachten. Bei sehr hohen Leistungsdichten kommt es zu einer verstärkten Ionisation des gesputterten Materials und somit zu einem stark veränderten Partikelstrom zum Substrat. Eine Änderung der Energie pro Puls (bzw. der Leistung pro Puls) würde somit die Ionisation ständig verändern, womit dem Ziel einer erhöhten Prozessstabilität auch über lange Zeiten entgegengewirkt würde.

Bei Variation der Frequenz bzw. des duty cycle bleibt jedoch die Form der individuellen Pulse und damit die Zusammensetzung der gesputterten Spezies unabhängig von der mittleren Leistung P. Diese erfindungsgemäße Frequenzvariation ermöglicht eine Prozessstabilisierung durch Leistungsanpassung ohne Variation der Entladungscharakteristik.

Erfindungsgemäß wird somit ein Verfahren zur Regelung eines reaktiven Hochleistungs-Puls-Sputterprozessen (insbesondere eines Magnetronsputterprozesses) zur Verfügung gestellt, bei dem mittels eines Regelkreises bzw. einer Regelungsschleife als Stellgröße die Entladungsleistung fortwährend kontinuierlich angepasst wird, indem die Pulsfrequenz der Entladung variiert wird.

In einer vorteilhaften Variante kann (siehe nachfolgendes Ausführungsbeispiel) dies dadurch geschehen, dass eine Sollwert-Prozesskurve aufgenommen und abgespeichert wird, indem für mehrere Sollwerte der Regelgröße jeweils ein für die Stellgröße einzustellender Wert bestimmt und abgespeichert wird und die Einstellung der Regelgröße auf den vorbestimmten Sollwert basierend auf der vorher abgespeicherten Sollwert-Prozesskurve erfolgt. Der vorbestimmte Sollwert bzw. Arbeitspunkt kann dann vorteilhafterweise so gewählt werden, dass der reaktive Hochleistungs-Puls-Sputterprozess im instabilen Übergangsbereich stabilisiert wird. Als Regelgröße lassen sich in vorteilhaften Ausgestaltungsvarianten des erfindungsgemäßen Verfahrens der Reaktivgaspartialdruck, der Targetstrom oder die Targetspannung, oder auch wie es bereits aus dem Stand der Technik bekannt ist, die optische Emission des Plasmas oder eine aus einer harmonischen Analyse des Spannungs- und/oder Stromsignals der Entladung abgeleitete Regelgröße verwenden.

Erfindungsgemäß werden somit ein Verfahren und eine Vorrichtung zur Regelung eines reaktiven Hochleistungs-Puls-Sputterprozesses zur Verfügung gestellt, welches bzw. welche dadurch gekennzeichnet ist, dass auf einer geeigneten Messung der Regelgröße basierend die Entladungsleistung durch Anpassung der Pulsfrequenz (bzw. alternativ dazu des duty cycles) angepasst wird, um die Entladung am gewünschten Arbeitspunkt (welcher dann vorzugsweise im instabilen Übergangsbereich oder transition mode gewählt wird) zu betreiben.

Die vorliegende Erfindung ermöglichst es somit, auf einfache Art und Weise den gewünschten Arbeitspunkt über eine schnelle und unkomplizierte Anpassung der Entladungsleistung über die Frequenz der Entladung einzustellen, ohne dass die Prozesscharakteristik nachteilig beeinflusst wird. Somit ermöglicht es die vorliegende Erfindung auf einfache Art und Weise einen reaktiven Hochleistungs-Puls-Sputterprozess zu stabilisieren, so dass Schichten mit der gewünschten Morphologie und Phasenzusammensetzung auf dem Substrat auf einfache Art und Weise abgeschieden werden können.

Erst hierdurch wird die Nutzung von vollreaktiven Prozessen von Materialien komplexer Struktur für das Gebiet der PVD-Verfahren mit hohen Ionisationsgraden ermöglicht. Insbesondere lassen sich mit den erfindungsgemäßen Verfahren die Nukleationsprozesse von dünnen Filmen (wie beispielsweise ZnO:Al-Dünnschichten) verbessern und somit auch die Ansätze für hoch qualitatives Kristallwachstum auf Filme geringerer Dicke übertragen. Es lassen sich somit dünne Schichten mit einer verbesserten Kristallinität und mit einem verbesserten spezifischen elektrischen Widerstand (beispielsweise auch unter 400 $\mu\Omega$cm) erzeugen. Insbesondere lassen sich mit dem erfindungsgemäßen Verfahren auch leitfähige und transparente TCO-Dünnschichten abscheiden. Besagte dünne Schichten (beispielsweise im Dickenbereich von 100 bis 150 nm) lassen sich insbesondere vorteilhaft für Flachbildschirme einsetzen. Dabei ist mit dem erfindungsgemäßen Verfahren die Deposition auf Substraten mit niedriger Substrattemperatur - neben der Abscheidung von dünnen Schichten mit Dicken kleiner als 400 nm - besonders vorteilhaft möglich.

Ein erfindungsgemäßes Verfahren bzw. eine erfindungsgemäße Vorrichtung kann wie in dem nachfolgenden Beispiel beschrieben ausgestaltet sein oder eingesetzt werden.

Im folgenden wird ein Beispiel für einen erfindungsgemäßen Prozess beschrieben. Es wird das reaktive HPPMS-Sputtern von aluminiumdotierten Zinkoxidschichten untersucht. Dazu wird eine Beschichtungsanlage mit einer Kathode einer Größe von 750 x 88 mm$^2$ verwendet. Die Kathode besteht aus Zink mit einem Aluminiumanteil von 1,0 Gew.-%. In die Kammer wird als Arbeitsgas Argon und als Reaktivgas Sauerstoff eingelassen. Eine Entladung wird mittels des in Christie, D.J.; Tomasel, F.; Sproul, W.D.; Carter, D.C.: Power supply with arc handling for high peak power magnetron sputtering In: Journal of Vacuum Science and Technology A 22 (2004), S. 1415-9, beschriebenen Generators gezündet, die Ladespannung für die Kondensatoren beträgt 1000 V.

Zur Vermessung des Reaktivgaspartialdrucks bzw. Sauerstoffpartialdrucks wird im vorliegenden Fall eine λ-Sonde eingesetzt. Die Entladung der Kondensatoren der Kondensatorbank geschieht mittels eines Frequenzgenerators, so dass die Frequenz der Entladung einfach eingestellt werden kann.

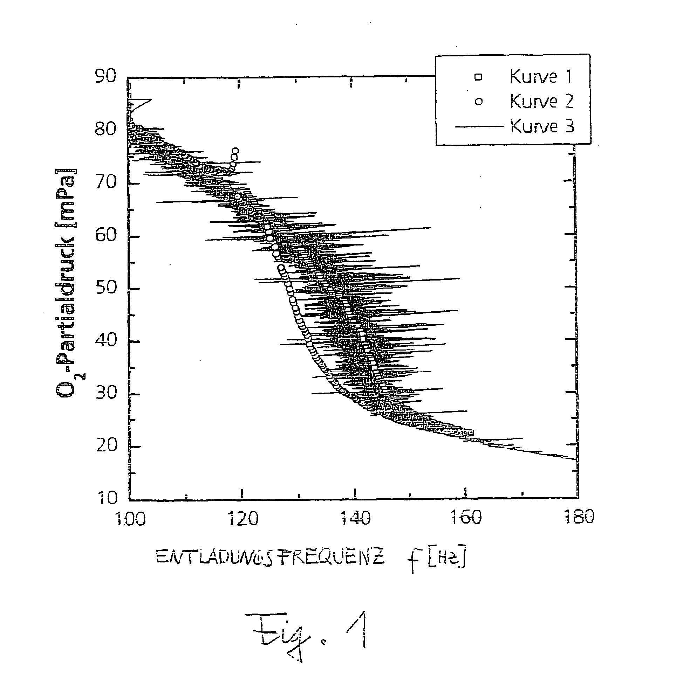

Zunächst wird eine Sollwert-Prozesskurve aufgenommen, indem der Sauerstoffpartialdruck als Funktion der Entladungsfrequenz f aufgenommen wird. Hierzu zeigt Kurve 1 in Figur 1 den Verlauf des Sauerstoffpartialdrucks (Ordinate) für ansteigende Entladungsfrequenzen f (Abszisse) und Kurve 2 den entsprechenden Verlauf für fallende Entladungsfrequenzen f. Man erkennt, dass hier keine eindeutige Beziehung zwischen der Entladungsfrequenz f (als einzustellende bzw. zu veränderte Stellgröße) und dem Sauerstoffpartialdruck (als gemessene Regelgröße) besteht, sondern dass sich unterschiedliche Kurven je nach Vorgeschichte der Entladung ergeben. Dieser Effekt ist als Hysterese beim reaktiven Sputterprozess bereits bekannt. Figur 1 zeigt die Hysterese des reaktiven Sputterprozesses von aluminiumdotierten Zinktargets unter Sauerstoffzugabe bei Variation der Entladungsleistung sowie mittels der Regelung stabilisierte Arbeitspunkte.

Mittels eines Regelkreises wird nun erfindungsgemäß die Entladung an verschiedenen Sauerstoffpartialdrücken stabilisiert. Der Regelkreis hält hierzu die Abweichung des gemessenen Sauerstoffpartialdrucks (gemessene Regelgröße) von seinem Sollwert klein, indem die Entladungsfrequenz wie nachfolgend noch genauer beschrieben unter Hinzunahme einer Sollwert-Prozesskurve (S-Kurve) verändert wird.

Zur Erstellung der Sollwert-Prozesskurve (S-Kurve) wird diese aufgenommen, indem der Sollwert des Sauerstoffpartialdrucks für die Regelschleife kontinuierlich gesteigert wird. Die zur Stabilisation des Sauerstoffpartialdrucks bei einem Sollwert benötigte Entladungsfrequenz f wird in einem Speicher der Vorrichtung abgelegt. Die Kurve 3 der Figur 1 zeigt die so erhaltene Prozesskurve. Wie zu erkennen ist, wird ein weiter Bereich von Sauerstoffpartialdrücken stabilisiert. Vor allem im interessierenden instabilen Übergangsbereich lassen sich keine großen Abweichungen vom Sollwert feststellen. Lediglich die zur Stabilisation des Arbeitspunktes notwendigen Frequenzen f können variieren, wie Figur 1 zeigt. Eine stabile Prozessführung ist dennoch an allen Arbeitspunkten möglich.

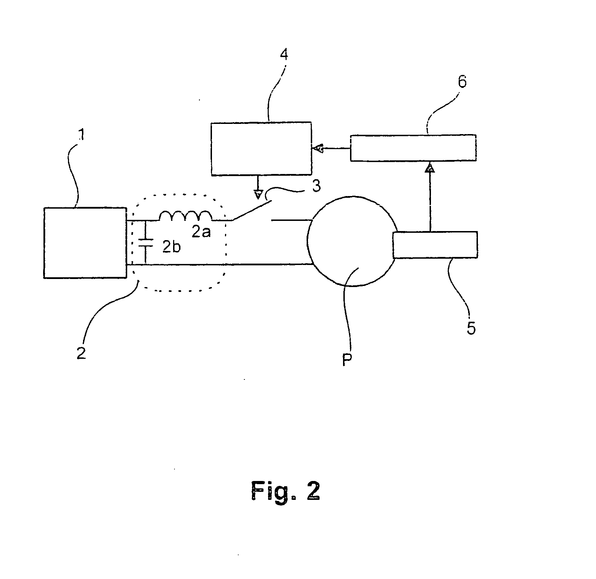

Den prinzipiellen schematischen Aufbau für eine Anlage, mit der das erfindungsgemäße Verfahren durchführbar ist, zeigt Figur 2. Hierbei ist mit dem Netzteil 1 ein Schwingkreis 2 verbunden. Dieser Schwingkreis besteht aus einem Kondensator 2b und einer Spule 2a. Mit Hilfe des Netzteils kann eine definierte Spannung $U_c$ an den Kondensator 2b angelegt werden (Aufladung des Kondensators). Der Kondensator 2b kann dann über die Spule 2a des Schwingkreises mit Hilfe eines Schalters 3 in das Plasma entladen werden. Für die im Kondensator gespeicherte Energie gilt: $E_{Puls}=0,5*C*U_C^2$ (c = Kapazität des Kondensators 2b, $U_C$ = Ladespannung des Kondensators). Die Entladung dieser Energie geschieht wie beschrieben in das Plasma P durch die Induktivität 2a. Der Sauerstoffpartialdruck wird durch eine Lambda-Sonde 5 bestimmt. Mit Hilfe des mit der Lambda-Sonde bestimmten Wertes des Sauerstoffpartialdrucks wird wie vorbeschrieben mit Hilfe der PID-Regelung 6 die Frequenz des Frequenzgenerators 4 variiert, somit die Pulsfrequenz der Entladung variiert.

Im beschriebenen Fall wird eine Zn/Al-Kathode mit einer Aluminiumkonzentration von 1,0 Gew.-% in einer Atmosphäre aus Sauerstoff und Argon gesputtert. Die Gasflussraten werden hierbei während des Beschichtungsprozesses vorteilhafterweise konstant gehalten. Die Argonflussrate und die Pumpgeschwindigkeiten werden an einen Gesamtdruck zwischen 650 und 800 mPa angepasst. Die Sauerstoffflussrate wird so ausgewählt, dass sowohl der metallische Modus als auch der Oxidmodus für eine gegebene definierte Targetspannung stabilisiert werden können, ohne dass weitere Änderungen notwendig sind (siehe nachfolgend). Die Deposition kann hierbei auf unbeheizten Substraten (mit Zimmertemperatur) ebenso wie auf Substraten, welche auf 200 °C erhitzt werden, ausgeführt werden. Als Substrat kann beispielsweise verwendet werden. Als Targetspannung können vorteilhafterweise Werte zwischen 700 V und 1200 V verwendet werden. Der Sauerstoffpartialdruck kann beispielsweise auf einen konstanten Wert zwischen 32,5 und 45 mPa eingestellt werden. Wie beschrieben ist sowohl eine Abscheidung bei Zimmertemperatur als auch beispielsweise bei erhitzten Substraten (200 °C Substrattemperatur) möglich. Bei Abscheidung mit einer Substrattemperatur von 200 °C können vorteilhafterweise auch höhere Sauerstoffpartialdrücke, z.B. mit Werten zwischen 45 und 70 mPa eingestellt werden.

Für die vorbeschriebene Sollwert-Prozesskurve (S-Kurve) wurden die folgenden Parameter verwendet:

| Prozess | HPPMS-Anregung bei einer Ladespannung von 1000 V, PK750-Kathode | | |
|---|---|---|---|
| Systemparameter | Target-SubstratAbstand | $d_{ST}$ | 90 mm |
| | Targetmaterial | | ZnO:Al (1,0 Gew.-%) |
| | Gas flow | $q_{Ar}$ | 2 x 50 sccm |
| | | $q_{02}$ | 45 sccm |
| Prozessparameter | Substrattemperatur<br>Totaldruck | $T_s$<br>$P_{tot}$ | 200 °C<br>650-750 mPa |

## Patentansprüche

1. Verfahren zur Regelung eines reaktiven Hochleistungs-Puls-Sputterprozesses,
   bei dem eine Regelgröße gemessen und basierend auf der gemessenen Regelgröße eine Stellgröße verändert wird, um die Regelgröße auf einen vorbestimmten Sollwert einzustellen,
   wobei als Stellgröße die Entladungsleistung verändert wird, indem die Pulsfrequenz der Entladung unter Beibehaltung der Form der einzelnen Entladungspulse variiert wird,
   ***dadurch gekennzeichnet, dass***
   der vorbestimmte Sollwert so gewählt wird, dass der reaktive Hochleistungs-Puls-Sputterprozess im instabilen Übergangsbereich stabilisiert wird.

2. Verfahren nach dem vorhergehenden Anspruch,
   ***dadurch gekennzeichnet, dass***
   eine Sollwert-Prozesskurve aufgenommen und abgespeichert wird, indem für mehrere Sollwerte der Regelgröße jeweils ein für die Stellgröße einzustellender Wert bestimmt und abgespeichert wird, und dass die Einstellung der Regelgröße auf den vorbestimmten Sollwert basierend auf der Sollwert-Prozesskurve erfolgt.

3. Verfahren nach einem der vorhergehenden Ansprüche,
   ***dadurch gekennzeichnet, dass***
   als Regelgröße der Reaktivgaspartialdruck, der Targetstrom, die Targetspannung, die optische Emission des Plasmas, der Totaldruck in der Sputterkammer oder eine aus einer harmonischen Analyse des Spannungs- und/oder Stromsignals der Entladung abgeleitete Regelgröße verwendet wird.

4. Verfahren nach dem vorhergehenden Anspruch,
   ***dadurch gekennzeichnet, dass***
   der Reaktivgaspartialdruck mittels einer Lambda-Sonde oder mittels eines Massenspektrometers gemessen wird.

5. Verfahren nach einem der vorhergehenden Ansprüche,
   ***dadurch gekennzeichnet, dass***
   die Pulsfrequenz der Entladung mit Hilfe eines Frequenzgenerators variiert wird.

6. Verfahren nach einem der vorhergehenden Ansprüche,
   ***dadurch gekennzeichnet, dass***
   die Regelungsschleife als Proportionalregelung, Differentialregelung oder Integralregelung ausgebildet wird.

7. Verfahren nach einem der vorhergehenden Ansprüche,
   ***dadurch gekennzeichnet, dass***
   mit Sauerstoff, Stickstoff oder einer Mischung daraus als Reaktivgas geregelt wird.

8. Verfahren nach einem der vorhergehenden Ansprüche,
   ***dadurch gekennzeichnet, dass***
   ein reaktiver Hochleistungs-Puls-Magnetronsputterprozess geregelt wird.

**9.** Vorrichtung zum reaktiven Hochleistungs-Puls-Sputtern mit
einer Sputterkammer,
einer Kathode, auf der das zu zerstäubende Target angeordnet ist,
einer mindestens einen Kondensator (2b) aufweisenden Kondensatorbank, mittels deren periodischer Entladung das Plasma aufbaubar ist, und
einer Regeleinheit (6),
wobei mit der Regeleinheit eine Regelgröße messbar ist,
wobei basierend auf der gemessenen Regelgröße eine Stellgröße veränderbar ist, um die Regelgröße auf einen vorbestimmten Sollwert einzustellen,
wobei die Vorrichtung ausgebildet ist zur Variation der Pulsfrequenz der Entladung der Kondensatoren (2b) der Kondensatorbank unter Beibehaltung der Form der einzelnen Entladungspulse, um die Entladungsleistung als Stellgröße zu verändern, und
wobei die Vorrichtung so ausgebildet ist, dass der vorbestimmte Sollwert so wählbar ist, dass der reaktive Hochleistungs-Puls-Sputterprozess im instabilen Übergangsbereich stabilisiert wird.

**10.** Vorrichtung nach dem vorhergehenden Vorrichtungsanspruch,
*gekennzeichnet durch*
einen mit der Kondensatorbank gekoppelten Frequenzgenerator (4), mit dem die Pulsfrequenz der Entladung variierbar ist **durch** Steuerung der Entladungscharakteristik der Kondensatoren (2b) der Kondensatorbank.

## Claims

**1.** Method for the control of a reactive high-power pulse sputter process,
wherein a control variable is measured and an adjustable variable is modified based on the measured control variable in order to adjust the control variable to a predetermined target value,
wherein, as the adjustable variable, the discharge capacity is modified by varying the pulse frequency of the discharge while maintaining the form of the individual discharge pulses,
**characterised in that**,
the predetermined target value is selected in such a way that the reactive high-capacity pulse sputter process is stabilised in the unstable transfer region.

**2.** Method according to the preceding claim,
**characterised in that**,
a target value process curve is recorded and stored while, for several target values of the control variable, one value to be adjusted for the adjustable variable is determined and stored respectively, and **in that** the adjustment of the control variable to the predetermined target value takes place based on the target value process curve.

**3.** Method according to one of the preceding claims,
**characterised in that**,
the reactive gas partial pressure, the target current, the target voltage, the optical emission of the plasma, the total pressure in the sputtering chamber or a control variable derived from an harmonic analysis of the voltage and/or current signal of the discharge is used as the control variable.

**4.** Method according to the preceding claim,
**characterised in that**,
the reactive gas partial pressure is measured by means of a lambda probe or by means of a mass spectrometer.

**5.** Method according to one of the preceding claims,
**characterised in that**,
the pulse frequency of the discharge is varied with the aid of a frequency generator.

**6.** Method according to one of the preceding claims,
**characterised in that**,
the control loop is designed as proportional control, differential control or integral control.

**7.** Method according to one of the preceding claims,
**characterised in that**,

the control takes place with oxygen, nitrogen or a mixture thereof as reactive gas.

8. Method according to one of the preceding claims,
**characterised in that**,
a reactive high-power pulse magnetron sputter process is controlled.

9. Device for reactive high-power pulse sputtering, with a sputtering chamber,
a cathode, on which the target that is to be atomised is arranged,
a capacitor bank having at least one capacitor (2b), by means of whose periodic discharge the plasma can be built up, and
a control unit (6),
wherein a control variable can be measured with the control unit,
wherein an adjustable variable can be modified based on the measured control variable in order to adjust the control variable to a predetermined target value,
wherein the device is designed for varying the pulse frequency of the discharge of the capacitors (2b) of the capacitor bank while maintaining the form of the individual discharge pulses in order to modify the discharge capacity as an adjustable variable, and
wherein the device is designed in such a way that the predetermined target value can be selected in such a way that the reactive high-power pulse sputter process is stabilised in the unstable transfer region.

10. Device according to the preceding device claim,
**characterised by**
a frequency generator (4) coupled to the capacitor bank, with which the pulse frequency of the discharge can be varied by controlling the discharge characteristics of the capacitors (2b) of the capacitor bank.

## Revendications

1. Procédé de régulation d'un processus réactif de pulvérisation cathodique pulsé à haute puissance,
où une variable réglée est mesurée et, sur la base de la variable réglée mesurée, une variable réglante est modifiée, pour ajuster la variable réglée à une valeur prescrite prédéterminée,
dans lequel, en tant que variable réglante, on modifie la puissance de décharge en faisant varier la fréquence des impulsions de la décharge en conservant la forme des impulsions de décharge individuelles,
**caractérisé en ce que** la valeur prescrite prédéfinie est choisie de telle sorte que le processus réactif de pulvérisation cathodique pulsé à haute puissance soit stabilisé dans la zone de transition instable.

2. Procédé selon la revendication précédente,
**caractérisé en ce qu'**une courbe de processus de la valeur prescrite est enregistrée et mémorisée, par le fait que pour plusieurs valeurs prescrites de la variable réglée, on détermine et mémorise, respectivement, une valeur à ajuster pour la variable réglante, et **en ce que** l'ajustement de la variable réglée à la valeur prescrite prédéterminée s'effectue sur la base de la courbe de processus de la valeur prescrite.

3. Procédé selon l'une des revendications précédentes,
**caractérisé en ce que**, en tant que variable réglée, on utilise la pression partielle du gaz réactif, le courant cible, la tension cible, l'émission optique du plasma, la pression totale dans la chambre de pulvérisation cathodique, ou une variable réglée déduite à partir d'une analyse harmonique du signal de tension et/ou de courant de la décharge.

4. Procédé selon la revendication précédente,
**caractérisé en ce que** la pression partielle du gaz réactif est mesurée au moyen d'une sonde lambda ou au moyen d'un spectromètre de masse.

5. Procédé selon l'une des revendications précédentes,
**caractérisé en ce qu'**on fait varier la fréquence des impulsions de la décharge à l'aide d'un générateur de fréquences.

6. Procédé selon l'une des revendications précédentes,
**caractérisé en ce que** la boucle de régulation est configurée sous forme d'une régulation proportionnelle, d'une régulation différentielle ou d'une régulation intégrale.

**7.** Procédé selon l'une des revendications précédentes,
**caractérisé en ce que** la régulation est effectuée avec de l'oxygène, de l'azote ou un mélange de ces derniers, utilisés en tant que gaz réactif.

**8.** Procédé selon l'une des revendications précédentes,
**caractérisé en ce que** la régulation porte sur un processus réactif de pulvérisation cathodique magnétron pulsé à haute puissance.

**9.** Dispositif pour la pulvérisation cathodique réactive à haute puissance à impulsions avec :

une chambre de pulvérisation cathodique,
une cathode sur laquelle est agencée la cible à pulvériser,
une batterie de condensateurs présentant au moins un condensateur (2b), via la décharge périodique de laquelle le plasma peut être constitué, et
une unité de régulation (6),
dans lequel une variable réglée avec l'unité de régulation peut être mesurée,
dans lequel, sur la base de la variable réglée mesurée, il est possible de modifier une variable réglante, pour ajuster la variable réglée à une valeur prescrite prédéterminée,
dans lequel le dispositif est configuré pour faire varier la fréquence des impulsions de la décharge des condensateurs (2b) de la batterie de condensateurs tout en conservant la forme des impulsions de décharge individuelles, pour modifier la puissance de décharge en tant que variable réglante, et
dans lequel le dispositif est configuré de telle sorte que la valeur prescrite prédéterminée puisse être choisie de façon à ce que le processus réactif de pulvérisation cathodique pulsé à haute puissance soit stabilisé dans la zone de transition instable.

**10.** Dispositif selon la revendication de dispositif précédente,
**caractérisé par** un générateur de fréquence (4), couplé à la batterie de condensateurs, à l'aide duquel il est possible de faire varier la fréquence des impulsions de la décharge par commande de la caractéristique de décharge des condensateurs (2b) de la batterie de condensateurs.

Fig. 1

Fig. 2

**EP 2 036 113 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19506515 C1

**In der Beschreibung aufgeführte Nicht-Patentliteratur**

- **D.J. CHRISTIE.** *Journal of Vacuum Science and Technology A,* 2005, vol. 23, 330-335
- **KOUZNETSOV, V. ; MACAK, K. ; SCHNEIDER, J.M. ; HELMERSSON, U. ; PETROV, I.** A novel pulsed magnetron sputter technique utilizing very high target power densities in. *Surface and Coatings Technology,* 1999, vol. 122, 290-3
- **D.J. CHRISTIE et al.** *48th SVC Proceedings,* 2005
- **D.A. GLOCKER et al.** *47th SVC Proceedings,* 2004, 183
- **W.D. SPROUL et al.** *47th SVC Proceedings,* 2004, 96 ff
- **CHRISTIE, D.J. ; TOMASEL, F. ; SPROUL, W.D. ; CARTER, D.C.** Power supply with arc handling for high peak power magnetron sputtering. *Journal of Vacuum Science and Technology A,* 2004, vol. 22, 1415-9